# EUROPEAN PATENT APPLICATION

(11) **EP 4 611 389 A1**
(43) Date of publication of application: **03.09.2025**
(21) Application number: 23937213.9
(22) Date of filing: 11.10.2023
(51) Int. Cl.: H04R 1/10, G10L 25/84

(54) **ACOUSTIC APPARATUS**

(30) Priority: 12.05.2023 CN 202310541798
(71) Applicant: Shenzhen Shokz Co., Ltd., Shenzhen, Guangdong 518108 (CN)
(72) Inventor: TONG, Peigeng, Shenzhen, Guangdong 518108 (CN); ZHANG, Sifu, Shenzhen, Guangdong 518108 (CN); XIE, Shuailin, Shenzhen, Guangdong 518108 (CN)
(74) Representative: Wang, Bo
(86) International application number: PCT/CN2023/124010
(87) International publication number: WO 2024/234538

(57) **Abstract**

The present disclosure provides an acoustic device (100) comprising a bone conduction microphone (110), at least one air conduction microphone (120), and a processing module (130). The bone conduction microphone (110) is configured to pick up a vibration generated when a user speaks to generate a first sound pickup signal. The at least one air conduction microphone (120) is configured to pick up an air-conducted sound generated when the user speaks to generate a second sound pickup signal. The processing module (130) is configured to synthesize a speech signal reflecting a speech content of the user based on a low-frequency component in the first sound pickup signal and a high-frequency component in the second sound pickup signal. The low-frequency component corresponds to frequencies below a first frequency division point, the high-frequency component corresponds to frequencies higher than the first frequency division point, and a resonant frequency of the bone conduction microphone (110) is higher than the first frequency division point.

## Description

### CROSS-REFERENCE TO RELATED APPLICATIONS

This application claims priority to Chinese Application No. 202310541798.X, filed on May 12, 2023, the entire contents of which are hereby incorporated by reference.

### TECHNICAL FIELD

The present disclosure relates to the field of acoustic technology, and in particular, to an acoustic device.

### BACKGROUND

For an acoustic device with a sound pickup function, such as an earphone, an unintended environmental pressure change may introduce an additional noise. For example, a wind noise caused by airflow has a non-stationary characteristic, and the frequency and amplitude of the wind noise change rapidly over time, and faster than a rate of a sound generated when a user speaks. For a microphone used in everyday application scenarios, the wind noise primarily originates from the pressure fluctuation of the air, i.e., when the air comes into contact with a diaphragm of the microphone, the air pushes the diaphragm to produce an unintended vibration. At the same time, there exists a highly random pulsating pressure whose amplitude is positively correlated with speed. The wind noise may affect the microphone's ability to pick up a sound signal, resulting in poor voice quality during a call of the user.

Therefore, it is desirable to provide an acoustic device that can reduce the impact of the wind noise and other noises, improve the quality of the sound signal captured by the acoustic device, and maintain good call performance.

### SUMMARY

One embodiment of the present disclosure provides an acoustic device. The acoustic device includes a bone conduction microphone, at least one air conduction microphone, and a processing module. The bone conduction microphone is configured to pick up a vibration generated when a user speaks to generate a first sound pickup signal. The at least one air conduction microphone is configured to pick up an air-conducted sound generated when the user speaks to generate a second sound pickup signal. The processing module is configured to synthesize a speech signal reflecting a speech content of the user based on a low-frequency component in the first sound pickup signal and a high-frequency component in the second sound pickup signal. The low-frequency component corresponds to frequencies below a first frequency division point, the high-frequency component corresponds to frequencies higher than the first frequency division point, and a resonant frequency of the bone conduction microphone is higher than the first frequency division point.

In some embodiments, the first frequency division point is within a range of 500 Hz to 1000 Hz.

In some embodiments, a difference between the resonant frequency of the bone conduction microphone and the first frequency division point is not less than 500 Hz.

In some embodiments, the acoustic device further includes a bone conduction vibrator and an air conduction vibrator. The bone conduction vibrator is configured to output a bone-conducted sound driven by a first sound signal. The air conduction vibrator is configured to output an air-conducted sound driven by a second sound signal. The first sound signal includes a component higher than a second frequency division point, the second sound signal includes a component lower than the second frequency division point, and the first frequency division point is lower than the second frequency division point.

In some embodiments, the second frequency division point is not less than 1000 Hz.

In some embodiments, the second frequency division point is within a range of 1000 Hz to 2500 Hz.

In some embodiments, a difference between the second frequency division point and the first frequency division point is within a range of 100 Hz to 2000 Hz.

In some embodiments, a ratio of the first frequency division point to the second frequency division point is within a range of 0.2 to 1.

In some embodiments, the acoustic device further includes a housing. The bone conduction microphone is disposed on a side of the housing, and the side of the housing is configured to contact the skin of the user.

In some embodiments, an angle between a vibration direction of the bone conduction microphone and a vibration direction of the bone conduction vibrator is not greater than 25°.

In some embodiments, the at least one air conduction microphone includes a first air conduction microphone and a second air conduction microphone. When the user wears the acoustic device, a connecting line between the first air conduction microphone and the second air conduction microphone points toward a mouth region of the user.

In some embodiments, a distance between the first air conduction microphone and the second air conduction microphone is within a range of 10 mm to 50 mm.

In some embodiments, in a wearing state, one of the first air conduction microphone and the second air conduction microphone is disposed in a low-flow velocity region on a side of the acoustic device facing the back of the head of the user.

In some embodiments, the processing module is further configured to determine whether the user is in a wind noise state based on an external sound signal collected by the first air conduction microphone and an external sound signal collected by the second air conduction microphone. If the user is in the wind noise state, the processing module controls the one, disposed in the low-flow velocity region, of the first air conduction microphone and the second air conduction microphone to collect a sound signal when the user is speaking. If the user is not in the wind noise state, the processing module controls one, closer to the mouth region of the user, of the first air conduction microphone and the second air conduction microphone to collect the sound signal when the user is speaking.

In some embodiments, to determine whether the user is in the wind noise state based on the external sound signal collected by the first air conduction microphone and the external sound signal collected by the second air conduction microphone, the processing module is further configured to determine whether a correlation between the external sound signal collected by the first air conduction microphone and the external sound signal collected by the second air conduction microphone is greater than a correlation threshold. If the correlation is greater than the correlation threshold, the processing module determines that the user is not in the wind noise state. If the correlation is less than the correlation threshold, the processing module determines that the user is in the wind noise state.

In some embodiments, the bone conduction microphone includes a first supporting structure and a vibration pickup unit. The vibration pickup unit is located in a cavity inside the first supporting structure, and includes an elastic element and a mass block, the mass block being located on the elastic element. The first supporting structure vibrates in response to a vibration of a housing or the skin of the user, and the vibration pickup unit receives the vibration of the first supporting structure and converts the vibration into an electrical signal.

In some embodiments, the bone conduction microphone includes a first supporting structure and a vibration pickup unit. The vibration pickup unit is located in a cavity inside the first supporting structure, and the first supporting structure is a closed structure.

In some embodiments, the air conduction microphone includes a second supporting structure and a diaphragm. The diaphragm is located in a cavity of the second supporting structure and divides the cavity into a front chamber and a rear chamber. The second supporting structure is provided with an opening for connecting the front chamber to an external environment.

In some embodiments, the processing module is further configured to: obtain a vibration signal through the bone conduction microphone, the vibration signal being at least partially derived from a vibration of a housing of the acoustic device in response to an audio signal, the vibration of the housing being configured to be transmitted to the user wearing the acoustic device in a bone conduction manner; determine a vibration response characteristic of the housing based on the vibration signal and the audio signal; and provide feedback on an operating state of the acoustic device based on the vibration response characteristic of the housing.

Additional features will be set forth in part in the following descriptions and will become apparent to those skilled in the art by consulting the following and the accompanying drawings or may be understood by the production or operation of the embodiments. The features of the present disclosure may be realized and obtained by practicing or using aspects of the methods, tools, and combinations set forth in the following detailed embodiments.

### BRIEF DESCRIPTION OF THE DRAWINGS

The present disclosure is further described in terms of exemplary embodiments. These exemplary embodiments are described in detail with reference to the drawings. These embodiments are non-limiting exemplary embodiments, in which like reference numerals represent similar structures throughout the views of the drawings, wherein:
FIG. 1 is a structural block diagram of an acoustic device according to some embodiments of the present disclosure;
FIG. 2 is a structural block diagram of an acoustic device according to some other embodiments of the present disclosure;
FIG. 3 is a schematic structural diagram of an exemplary bone conduction microphone according to some embodiments of the present disclosure;
FIG. 4 is a schematic structural diagram of another exemplary bone conduction microphone according to some embodiments of the present disclosure;
FIG. 5 is a schematic structural diagram of yet another exemplary bone conduction microphone according to some embodiments of the present disclosure;
FIG. 6 is a schematic structural diagram of an air conduction microphone according to some embodiments of the present disclosure;
FIG. 7 is a schematic structural diagram of a sound inlet opened on a housing according to some embodiments of the present disclosure;
FIG. 8 is a schematic cross-sectional view taken along a line M1-M2 of FIG. 7 according to some embodiments of the present disclosure;
FIG. 9 is a schematic cross-sectional view taken along a line M3-M4 of FIG. 8 according to some embodiments of the present disclosure;
FIG. 10 is a schematic structural diagram of a bone conduction microphone according to some embodiments of the present disclosure;
FIG. 11 is a schematic structural diagram of an air conduction microphone according to some embodiments of the present disclosure; and
FIG. 12 is a structural diagram of an acoustic device according to some embodiments of the present disclosure.

### DETAILED DESCRIPTION

To more clearly illustrate the technical solutions of the embodiments of the present disclosure, the accompanying drawings to be used in the description of the embodiments will be briefly described below. Obviously, the accompanying drawings in the following description are only some examples or embodiments of the present disclosure, and that the present disclosure may be applied to other similar scenarios in accordance with these drawings without creative labor for those of ordinary skill in the art. Unless obviously acquired from the context or the context illustrates otherwise, the same numeral in the drawings refers to the same structure or operation.

As indicated in the present disclosure and the claims, the singular forms "a," "an," and "the" may be intended to include the plural forms as well, unless the context clearly indicates otherwise. In general, the terms "comprise," "comprises," and/or "comprising," "include," "includes," and/or "including," when used in this disclosure, specify the presence of stated features, integers, steps, operations, elements, and/or components, but do not preclude the presence or addition of one or more other features, integers, steps, operations, elements, components, and/or groups thereof.

It should be noted that in the descriptions of the present disclosure, the words "front," "rear," "ear-hook," "rear-hook," etc., indicate orientations or positional relationships based only on the orientations or positional relationships shown in the accompanying drawings. These words are intended only to facilitate the description of the present disclosure and to simplify the description, and are not intended to indicate or imply that the device, component, element, etc. referred to must have a particular orientation, be constructed and operated in a particular orientation, or be of a particular type. Therefore, these words are not to be construed as a limitation of the present disclosure.

Additionally, the terms "first" and "second" are used only for descriptive purposes and are not to be construed as indicating or implying relative importance or implicitly specifying the number of technical features indicated. Thus, a feature defined with "first," "second" may expressly or implicitly include at least one feature. In the description of the present disclosure, "a plurality of" and "the plurality of" mean at least two, e.g., two, three, or the like, unless explicitly and specifically limited otherwise.

In the present disclosure, unless otherwise expressly specified or limited, the words "mounted," "installed," "connected," "fixed," etc. should be understood in a broad sense. For example, the words may indicate a fixed connection, a removable connection, a one-piece connection, a mechanical connection, an electrical connection, a direct connection, an indirect connection through an intermediate medium, a connection within two components, a connection between two components, an interactive relationship between the two components, unless otherwise expressly limited. To a person of ordinary skill in the art, the specific meaning of the above words in the present disclosure may be understood on a case-by-case basis.

Embodiments of the present disclosure provide an acoustic device that picks up a vibration generated when a user speaks by a bone conduction microphone to generate a first sound pickup signal, picks up an air-conducted sound generated when the user speaks by at least one air conduction microphone to generate a second sound pickup signal, and synthesizes, by a processing module, a speech signal reflecting a speech content of the user based on a low-frequency component in the first sound pickup signal and a high-frequency component in the second sound pickup signal. The low-frequency component corresponds to frequencies below a first frequency division point, the high-frequency component corresponds to frequencies higher than the first frequency division point, and a resonant frequency of the bone conduction microphone is higher than the first frequency division point, so as to reduce the influence of wind noise, improve the quality of the sound signal the acoustic device picks up, and maintain a better call effect. In some embodiments, the acoustic device may include a bone conduction vibrator. By configuring frequency components of an electrical signal driving the vibration of the bone conduction vibrator, on one hand, a listening effect for the user can be optimized, and on the other hand, a vibration frequency of the bone conduction vibrator can be set apart from the low-frequency component in the first sound pickup signal. Thus, the vibration of the bone conduction vibrator can be prevented from affecting the sound pickup effect of the bone conduction microphone.

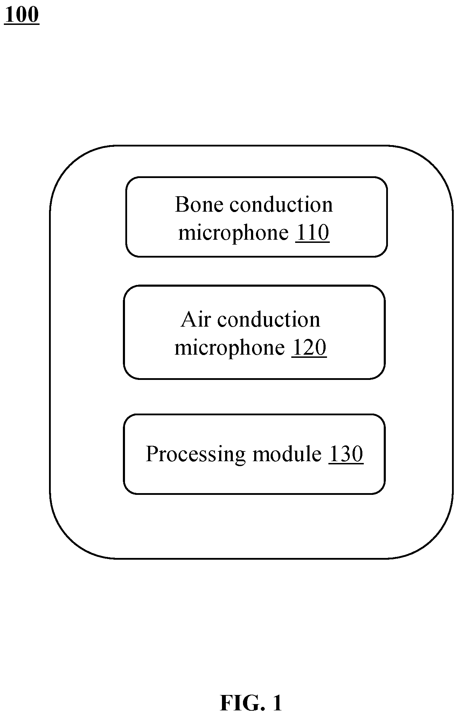

FIG. 1 is a structural block diagram of an acoustic device according to some embodiments of the present disclosure.

As shown in FIG. 1, in some embodiments, an acoustic device 100 may include a housing, a bone conduction microphone 110, at least one air conduction microphone 120, and a processing module 130. The bone conduction microphone 110, the at least one air conduction microphone 120, and the processing module 130 are disposed within the housing.

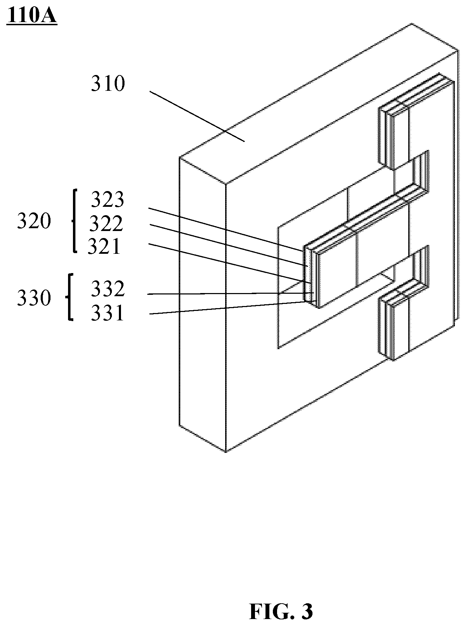

The bone conduction microphone 110 refers to a device for picking up an external vibration signal and converting the external vibration signal into an electrical signal, i.e., a first sound pickup signal. The external vibration signal may include a vibration generated by a user's skin, bones, muscles, etc. when the user speaks. In some embodiments, the bone conduction microphone 110 may receive the external vibration through the housing, which transmits the vibration to the bone conduction microphone 110. The bone conduction microphone 110 receives a vibration of the housing and converts the vibration into a first sound pickup signal. Merely by way of example, the bone conduction microphone 110 described in the embodiments of the present disclosure may be applied to an earphone (e.g., a bone conduction earphone, an air conduction earphone, or a bone-air conduction earphone), a pair of glasses, a virtual reality device, a helmet, or the like. The bone conduction microphone may be placed in a location on the head (e.g., the face, the top of the head, or the like), the neck, near the ears, or the like. The bone conduction microphone 110 may pick up a vibration signal generated by the skin, the bones, the muscles, etc., of the user when the user speaks and convert the vibration signal into an electrical signal to realize the acquisition of sound. Specific structures of the bone conduction microphone will be described below in conjunction with FIG. 3 to FIG. 5.

In some embodiments, the bone conduction microphone 110 may include a substrate structure and a stacked structure. In some embodiments, the substrate structure may be a regular or irregular three-dimensional structure with a hollow portion inside. For example, the substrate structure may be a hollow frame structural body including, but not limited to, regular shapes such as a rectangular frame, a circular frame, a square polygonal frame, and irregular shapes. The stacked structure may be disposed in the hollow portion of the substrate structure or at least partially suspended over the hollow portion of the substrate structure. In some embodiments, at least a portion of the stacked structure is physically connected to the substrate structure. The term "connected" may be understood as fixing and connecting the stacked structure and the substrate structure through welding, riveting, snap-fitting, bolting, etc., after preparing the stacked structure and the substrate structure separately, or depositing the stacked structure on the substrate structure through physical deposition (e.g., physical vapor deposition) or chemical deposition (e.g., chemical vapor deposition) in the preparing process. In some embodiments, at least a portion of the stacked structure may be fixed to an upper surface or a lower surface of the substrate structure, and the at least a portion of the stacked structure may also be fixed to a sidewall of the substrate structure. FIG. 3 is a schematic structural diagram of an exemplary bone conduction microphone according to some embodiments of the present disclosure. As shown in FIG. 3, in some embodiments, a bone conduction microphone 110A may include a substrate structure 310 and a stacked structure, and the stacked structure is fixedly connected to the substrate structure 310 in the form of a cantilever beam. Further, the stacked structure may include a fixed end and a free end, wherein the fixed end of the stacked structure is fixedly connected to the frame structural body, and the free end of the stacked structure is not connected to or in contact with the frame structural body, such that the free end of the stacked structure can be set in suspension. In some embodiments, the fixed end of the stacked structure may be connected to the upper surface or the lower surface of the substrate structure 310, or the sidewall of the substrate structure 310 where the hollow portion of the substrate structure 310 is located. In some embodiments, the stacked structure may include an acoustic transducer unit 320 and a vibration unit 330. The vibration unit 330 is a portion of the stacked structure that can undergo an elastic deformation, and the acoustic transducer unit 320 is a portion of the stacked structure that converts the deformation of the vibration unit 330 into an electrical signal. In some embodiments, the vibration unit 330 may be disposed on an upper surface or a lower surface of the acoustic transducer unit 320. In some embodiments, the vibration unit 330 may include at least one elastic layer. Merely by way of example, as shown in FIG. 3, the vibration unit 330 may include a first elastic layer 331 and a second elastic layer 332 disposed sequentially from top to bottom. Each of the first elastic layer 331 and the second elastic layer 332 may be configured as a plate-like structure made of a semiconductor material. In some embodiments, the semiconductor material may include silicon dioxide, silicon nitride, gallium nitride, zinc oxide, silicon carbide, or the like. In some embodiments, a material of the first elastic layer 331 and a material of the second elastic layer 332 may be the same or different. In some embodiments, the acoustic transducer unit 320 includes at least a first electrode layer 321, a piezoelectric layer 322, and a second electrode layer 323 disposed sequentially from top to bottom, wherein the elastic layer (e.g., the first elastic layer 331 and the second elastic layer 332) may be disposed on an upper surface of the first electrode layer 321 or a lower surface of the second electrode layer 323. The piezoelectric layer 322 may generate a voltage (i.e., a potential difference) under a deformation stress of the vibration unit 330 (e.g., the first elastic layer 331 and the second elastic layer 332) based on a piezoelectric effect, and the first electrode layer 321 and the second electrode layer 323 may derive the voltage (an electrical signal). In some embodiments, a material of the piezoelectric layer may include a piezoelectric crystal material and a piezoelectric ceramic material. The piezoelectric crystal material is a piezoelectric single crystal. In some embodiments, each of the first electrode layer 321 and the second electrode layer 323 may be configured as an electrically conductive material structure. Exemplary electrically conductive materials may include a metal, an alloy material, a metal oxide material, graphene, etc., or any combination thereof.

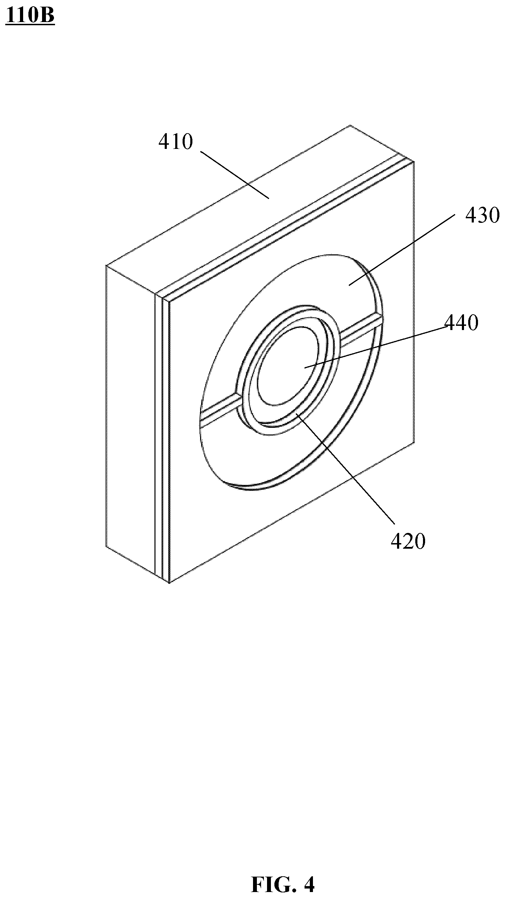

FIG. 4 is a schematic structural diagram of another exemplary bone conduction microphone according to some embodiments of the present disclosure. As shown in FIG. 4, in some embodiments, a bone conduction microphone 110B may include a substrate structure 410 and a stacked structure, and the stacked structure may include an acoustic transducer unit 420 and a vibration unit. In some embodiments, the vibration unit may be disposed on an upper surface or a lower surface of the acoustic transducer unit 420. As shown in FIG. 4, the vibration unit includes a suspension membrane structure 430 and a mass element 440, and the mass element 440 may be disposed on an upper surface or a lower surface of the suspension membrane structure 430. In some embodiments, the suspension membrane structure 430 may be disposed on an upper surface or a lower surface of the substrate structure 410. In some embodiments, a circumferential side of the suspension membrane structure 430 may be connected to an inner wall of the hollow portion of the substrate structure 410. In some embodiments, the acoustic transducer unit 420 may include a first electrode layer, a second electrode layer, and a piezoelectric layer disposed between the two electrode layers. The first electrode layer, the piezoelectric layer, and the second electrode layer are combined to form a structural body that is shape-adapted to the mass element 440. For example, if the mass element 440 is a cylindrical structure, the acoustic transducer unit 420 may be an annular structure, where the first electrode layer, the piezoelectric layer, and the second electrode layer are annular structures, and are arranged sequentially from top to bottom to form an annular structure.

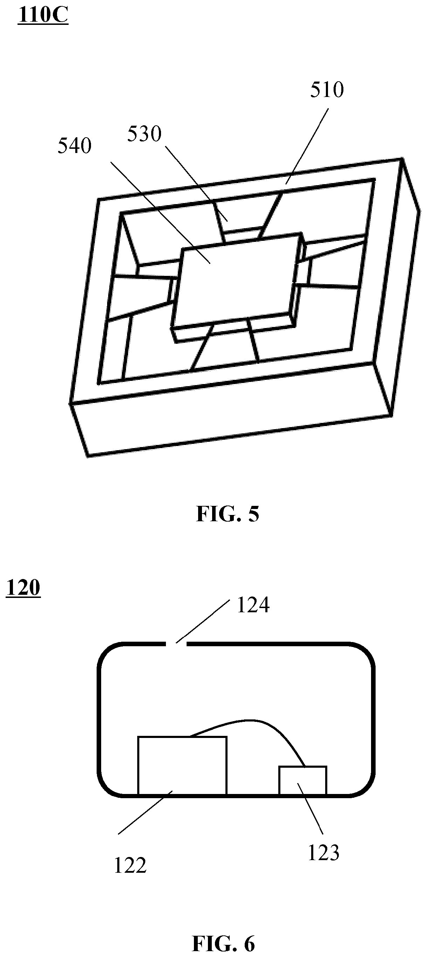

In some embodiments, the stacked structure may include the mass element and one or more support arms, and the mass element is fixedly connected to the substrate structure via the one or more support arms. An end of each of the one or more support arms is connected to the substrate structure, and another end of each of the one or more support arms is connected to the mass element, such that a portion of the mass element and the support arm is cantileveredly disposed in the hollow portion of the substrate structure. FIG. 5 is a schematic structural diagram of yet another exemplary bone conduction microphone according to some embodiments of the present disclosure. As shown in FIG. 5, a bone conduction microphone 110C may include a substrate structure 510 and a stacked structure. The stacked structure includes four support arms 530 and a mass block 540. An end of each of the four support arms 430 is connected to an upper surface, a lower surface, or a sidewall where a hollow portion of the substrate structure 410 is located, and another end of each of the four support arms 430 is connected to an upper surface, a lower surface, or a circumferential sidewall of the mass block 440. Each of the support arms 430 may include at least one elastic layer. The elastic layer may be configured as a plate-like structure made of a semiconductor material. In some embodiments, materials of different elastic layers of the support arm 430 may be the same or different. Further, the bone conduction microphone 110C may include an acoustic transducer unit 420. The acoustic transducer unit 420 may include a first electrode layer, a piezoelectric layer, and a second electrode layer arranged in sequence. The first electrode layer or the second electrode layer is connected to an upper surface or a lower surface of the support arm 430 (e.g., an elastic layer). In some embodiments, when the support arm 430 includes a plurality of elastic layers, the acoustic transducer unit 420 may be disposed between the plurality of elastic layers. The piezoelectric layer may generate a voltage (i.e., a potential difference) under a deformation stress of the vibrating unit (e.g., the support arm 430 and the mass element 440) based on a piezoelectric effect, and the first electrode layer and the second electrode layer may derive the voltage (an electrical signal).

It may be understood that "disposed in a hollow portion of the substrate structure" or "suspended over a hollow portion of the substrate structure" in the present disclosure may indicate disposed in or suspended over an inner portion, a lower portion, or an upper portion of the hollow portion of the substrate structure. Specifically, the substrate structure may generate a vibration based on an external vibration signal, and the vibration unit undergoes a deformation in response to the vibration of the substrate structure. The acoustic transducer unit generates an electrical signal based on the deformation of the vibration unit. It may be understood that the vibration unit and the acoustic transducer unit described herein are only for the purpose of facilitating the introduction of the working principle of the stacked structure, and do not limit the actual composition and structure of the stacked structure. In fact, the vibration unit may not be necessary, and its function may be fully realized by the acoustic transducer unit. For example, the structure of the acoustic transducer unit may be altered in a way that the acoustic transducer unit generates an electrical signal in direct response to the vibration of the substrate structure.

The air conduction microphone 120 refers to a transducer device that picks up an air-conducted sound propagated through the air to generate an electrical signal, i.e., a second sound pickup signal. The air-conducted sound may include sound waves generated by a vibration of the surrounding air when the user speaks. FIG. 6 is a schematic structural diagram of an air conduction microphone according to some embodiments of the present disclosure. As shown in FIG. 6, in some embodiments, the air conduction microphone 120 may include a sound sensor 122, a processing circuit 123, or the like. The sound sensor 122 and the processing circuit 123 may be disposed in the interior of the housing of the acoustic device, and the sound sensor 122 and the processing circuit 123 are electrically connected to each other via a lead. The sound sensor 122 is configured to convert the air-conducted sound into an electrical signal. In some embodiments, the sound sensor 122 may include one or more of a moving coil sound sensor, a moving iron sound sensor, a capacitive sound sensor, a piezoelectric sound sensor, a MEMS sound sensor, or the like. The processing circuit 123 is configured to receive and process the electrical signal converted by the sound sensor 122. In some embodiments, the processing circuit 123 may include an amplifier, a filter processor, or the like. Taking the moving coil sound sensor as an example for illustration, the moving coil sound sensor includes at least a diaphragm, a coil, and a magnetic circuit structure (not shown in FIG. 6). A sound inlet 124 is provided on the housing, allowing an external sound to transmit an air-conducted sound wave into the interior of the housing through the sound inlet 124. The pressure change inside the housing causes the diaphragm to vibrate, and the coil moves in response to the vibration of the diaphragm. The coil moves within a magnetic field of the magnetic circuit structure and generates an electrical signal.

In some embodiments, the shape of the housing of the acoustic device may be rectangular, nearly rectangular, cylindrical, spherical, or any other shape. The housing encloses to form an accommodation cavity, the air conduction microphone 120 is disposed within the accommodation cavity, and the bone conduction microphone 110 may be disposed on an outer surface of the housing or within the housing. In some embodiments, the bone conduction microphone 110 and the air conduction microphone 120 are physically connected to the housing. The physical connection may include connections achieved through welding, snapping, adhesive bonding, unibody molding, or the like. The connection manners are not limited herein. In some embodiments, the housing may be made of a material having a degree of hardness, such that the housing may protect the bone conduction microphone 110 and the air conduction microphone 120 and other internal components. In some embodiments, the material of the housing may include, but is not limited to, one or more of a metal, an alloy material (e.g., an aluminum alloy, a chromium-molybdenum steel, a scandium alloy, a magnesium alloy, a titanium alloy, a magnesium-lithium alloy, a nickel alloy, or the like), a fiberglass or carbon fiber, a polymer material (e.g., an acrylonitrile-butadiene-styrene copolymer, polyvinyl chloride, a polycarbonate, polypropylene, or the like), or the like.

The processing module 130 may perform signal processing on the first sound pickup signal converted by the bone conduction microphone 110 and the second sound pickup signal converted by the air conduction microphone 120, and ultimately generate a speech signal reflecting a speech content of the user. In some embodiments, the processing module 130 may extract different frequency components from the first sound pickup signal and the second sound pickup signal, respectively. For example, the processing module 130 may extract a low-frequency component in the first sound pickup signal and a high-frequency component in the second sound pickup signal, generate the speech signal reflecting the speech content of the user based on the extracted low-frequency component in the first sound pickup signal and the high-frequency component in the second sound pickup signal, and synthesize the speech signal based on the extracted frequency components. The low-frequency component refers to a signal portion of the first sound pickup signal corresponding to a low-frequency sound, and the high-frequency component refers to a signal portion of the first sound pickup signal corresponding to a high-frequency sound. In actual application scenarios, the speech signal generated by the processing module 130 based on different frequency components extracted from the first sound pickup signal and the second sound pickup signal reflecting the content of the speech of the user generally has a splicing trace. The splicing trace may reflect the absence of the speech signal or a significant difference in amplitude of the speech signal near a first frequency division point (i.e., within ±300 Hz of the first frequency division point). In some embodiments, the low-frequency component and the high-frequency component described herein may be differentiated by a frequency point, more descriptions of which may be found in related descriptions below. The signal processing described above may include, but is not limited to, one or more of signal amplification, phase adjustment, filtering processing, or the like. In some embodiments, the processing module 130 may include, but is not limited to, an equalizer (EQ), a dynamic range controller (DRC), a phase processor (GAIN), or the like. The processing module 130 is not limited to the above-described circuit structure for processing the signal, and in some embodiments, the processing module 130 may also be a computer storage medium that contains a processing algorithm. It should be noted that the processing module 130 may also function as the processing circuit 123 of the air conduction microphone 120, and at this point, the processing circuit 123 may be omitted.

When the user speaks, compared to the high-frequency sound, the vibration accompanying the low-frequency sound may effectively be transmitted through the bones and muscles of the human body to the skin. At this time, using the bone conduction microphone 110 to capture the vibration generated when the user speaks can effectively pick up low-frequency information in the vibration. Meanwhile, although a wind noise is primarily concentrated in a low-frequency range, since the wind noise mainly relies on air conduction, the low-frequency component captured by the bone conduction microphone 110 is minimally affected by the wind noise. In other words, the low-frequency component in the bone conduction microphone 110 can avoid the impact of the wind noise. Additionally, the wind noise has a relatively weak effect on the high-frequency sound. Using the air conduction microphone 120 to capture the air-conducted sound generated when the user speaks can effectively pick up high-frequency information in the air-conducted sound. In some embodiments, by using the bone conduction microphone 110 and the air conduction microphone 120 to separately capture the sound when the user speaks, and processing the signal through the processing module 130, the low-frequency component of the first sound pickup signal and the high-frequency component of the second sound pickup signal can be obtained and combined to synthesize the speech signal of the user. This approach can reduce the impact of the wind noise while improving the quality of sound signals captured by the acoustic device 100 across different frequency ranges.

In some embodiments, the low-frequency component corresponds to frequencies below the first frequency division point, and the high-frequency component corresponds to frequencies higher than the first frequency division point. The first frequency division point is a sound frequency that distinguishes the low-frequency component from the high-frequency component. It should be noted that the frequencies corresponding to the low-frequency component are sound frequencies below the first frequency division point, and the frequencies corresponding to the high-frequency component are sound frequencies higher than the first frequency division point.

The impact of the wind noise on the sound when the user speaks is mainly in a frequency range below 1000 Hz, exhibiting a decreasing characteristic from low to high frequencies. Based on this, to reduce the impact of the wind noise on the sound signals captured by the microphone when the user speaks, in some embodiments, the first frequency division point may be set within a range of 500 Hz to 1000 Hz. In this case, the bone conduction microphone is in contact with a facial skin of the user and captures sound signals below the first frequency division point based on a facial vibration when the user speaks, thereby significantly reducing the impact of the wind noise on the low-frequency range of the sound generated when the user speaks. Furthermore, the wind noise has a minimal effect on the high-frequency sound. By using the air conduction microphone to capture the air-conducted sound generated when the user speaks, that is to say, by using the air conduction microphone to capture sound signals higher than the first frequency division point, the high-frequency information in the sound signals can be effectively collected.

In some embodiments, the first frequency division point may be 500 Hz, at which point the low-frequency component of the first sound pickup signal may include a frequency component of 20 Hz-500 Hz, and the high-frequency component of the second sound pickup signal may include a frequency component above 500 Hz (e.g., 500 Hz-8000 Hz). In some embodiments, the first frequency division point may be 800 Hz, at which point the low-frequency component of the first sound pickup signal may include a frequency component of 20 Hz-800 Hz, and the high-frequency component of the second sound pickup signal may include a frequency component above 800 Hz (800 Hz-8000 Hz). In some embodiments, the first frequency division point may be 900 Hz, at which point the low-frequency component of the first sound pickup signal may include a frequency component of 20 Hz-900 Hz, and the high-frequency component of the second sound pickup signal may include a frequency component above 900 Hz (900 Hz-8000 Hz). In some embodiments, the first frequency division point may be 1000 Hz, at which point the low-frequency component of the first sound pickup signal may include a frequency component of 20 Hz-1000 Hz, and the high-frequency component of the second sound pickup signal may include a frequency component above 1000 Hz (e.g., 1000 Hz-8000 Hz).

It should be noted that, for sound frequencies below the first frequency division point, the wind noise has less impact on the bone conduction microphone 110, while the impact on the air conduction microphone 120 is greater. At this time, the low-frequency component of the sound pickup signal picked up by the bone conduction microphone 110 may more accurately reflect the low-frequency information in the sound generated when the user speaks. For the sound frequencies higher than the first frequency division point, due to the human skeleton and skin, the transmission of vibration may cause a relatively large attenuation. Compared to the bone conduction microphone 110, the high-frequency component of the sound pickup signal picked up by the air conduction microphone 120 can better reflect the high-frequency information in the sound generated when the user speaks.

In some embodiments of the present disclosure, by setting the first frequency division point, it is possible to accurately extract and combine an optimal portion of the sound signal collected by the bone conduction microphone 110 and an optimal portion of the sound signal collected by the air conduction microphone 120, respectively, to synthesize the speech signal when the user speaks. By leveraging the respective advantages of the bone conduction microphone 110 and the air conduction microphone 120 in different frequency ranges, the overall quality of the speech signal of the user is enhanced.

In some embodiments, the first frequency division point may be determined based on physical characteristics or electronic characteristics of the bone conduction microphone 110 and the air conduction microphone 120. For example, a frequency spectrum of the synthesized speech signal from the acoustic device 100 may be obtained, and a frequency at which a sudden change in signal amplitude occurs or a frequency range where discontinuous changes occur may be identified. The first frequency division point may be determined based on the frequency or the frequency range. Merely by way of example, the frequency at which a sudden change in signal amplitude occurs in the spectrum may be designated as the first frequency division point, or the frequency range where discontinuous changes in signal amplitude occur may be designated as a range for selecting the first frequency division point. The first frequency division point may be chosen within the range.

In some embodiments, the processing module 130 may perform low-pass filtering processing on the first sound pickup signal via a low-pass filter to obtain the low-frequency component, perform high-pass filtering processing on the second sound pickup signal via a high-pass filter to obtain the high-frequency component, and perform splicing of the obtained low-frequency component and the high-frequency component to obtain a complete speech signal.

In some embodiments, a cutoff frequency of the low-pass filter is set as the first frequency division point. After the first sound pickup signal generated by the bone conduction microphone 110 undergoes low-pass filtering, a portion exceeding the cutoff frequency (i.e., the first frequency division point) is filtered out, thereby primarily retaining the low-frequency component below the cutoff frequency. Similarly, a cutoff frequency of the high-pass filter is set as the first frequency division point. After the second sound pickup signal generated by the air conduction microphone 120 undergoes high-pass filtering, a portion below the cutoff frequency (i.e., the first frequency division point) is filtered out, thereby primarily retaining the high-frequency component above the cutoff frequency. In some embodiments, the cutoff frequency of the low-pass filter may be set lower than the cutoff frequency of the high-pass filter, thereby clearly distinguishing the low-frequency component of the first sound pickup signal from the high-frequency component of the second sound pickup signal. In some embodiments, the cutoff frequency of the low-pass filter may be set higher than the cutoff frequency of the high-pass filter to obtain an overlapping frequency component between the low-frequency component of the first sound pickup signal and the high-frequency component of the second sound pickup signal, thereby effectively mitigates the abrupt change in the synthesized speech signal near the first frequency division point. In some embodiments, a difference between the cutoff frequency of the high-pass filter and the cutoff frequency of the low-pass filter may be within a range of 200 Hz, thereby ensuring that the low-frequency component and high-frequency component of the signal synthesized by the processing module 130 maintain high quality while avoiding the impact of the wind noise. It should be noted that the filter (e.g., the high-pass filter and the low-pass filter) described in the present disclosure may be an electronic component or a computer medium including a filtering algorithm.

In some embodiments, a resonant frequency of the bone conduction microphone 110 is higher than the first frequency division point.

In some embodiments of the present disclosure, a frequency response curve of the bone conduction microphone 110 exhibits rapid attenuation after a resonant peak of the bone conduction microphone 110, which affects the quality of the captured sound. By setting the resonant frequency of the bone conduction microphone 110 higher than the first frequency division point, the frequency response curve of the bone conduction microphone 110 remains relatively flat and maintains a high amplitude before the first frequency division point, thereby allowing the bone conduction microphone to effectively capture more low-frequency components, and ensuring the quality of the synthesized sound. In some embodiments, the resonant frequency of the bone conduction microphone 110 may be within a range of 2 kHz to 5 kHz. In some embodiments, to enhance the sensitivity of the bone conduction microphone 110 to low-frequency vibration, a difference between the resonant frequency of the bone conduction microphone 110 and the first frequency division point may be set to no more than 4 kHz. In some embodiments, the difference between the resonant frequency of the bone conduction microphone 110 and the first frequency division point may be set to no more than 3 kHz. In some embodiments, to improve the flatness of the frequency response curve of the bone conduction microphone 110 at the first frequency division point, the difference between the resonant frequency of the bone conduction microphone 110 and the first frequency division point may be set to not less than 500 Hz. In some embodiments, the difference between the resonant frequency of the bone conduction microphone 110 and the first frequency division point may be set to not less than 1 kHz.

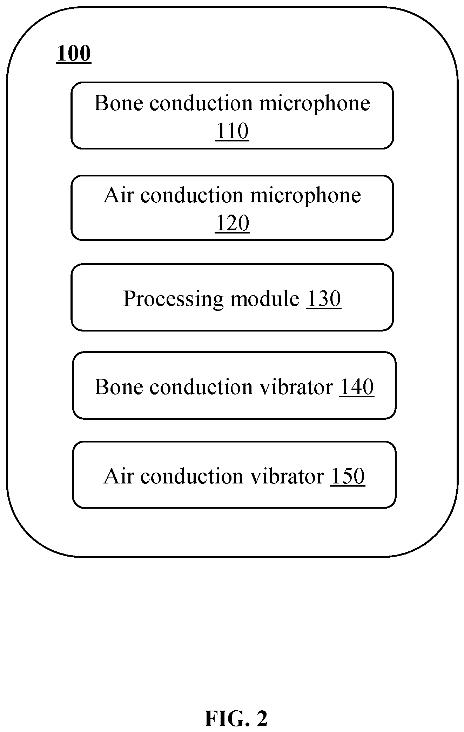

FIG. 2 is a structural block diagram of an acoustic device according to some other embodiments of the present disclosure.

As shown in FIG. 2, in some embodiments, the acoustic device 100 further includes a bone conduction vibrator 140 and an air conduction vibrator 150. The bone conduction vibrator 140 is configured to output a bone-conducted sound driven by a first sound signal, and the air conduction vibrator 150 is configured to output an air-conducted sound driven by a second sound signal. The first sound signal includes a component higher than a second frequency division point, the second sound signal includes a component lower than the second frequency division point, and the first frequency division point is lower than the second frequency division point.

The second frequency division point may be used to define frequency components of an electrical signal containing sound information from a loudspeaker (e.g., the bone conduction vibrator 140 and the air conduction vibrator 150). In some embodiments, the processing module 130 may divide the input electrical signal containing the sound information into a first sound signal and a second sound signal based on the second frequency division point and send the first sound signal and the second sound signal to the bone conduction vibrator 140 and the air conduction vibrator 150, respectively, to generate a corresponding sound.

In some embodiments of the present disclosure, the bone conduction vibrator 140 may include a magnetic circuit structure, a coil, a vibration transmitting member, a vibration plate (which may also be a housing of the acoustic device). The coil generates a change in a magnetic field based on an electrical signal. The magnetic circuit structure generates a vibration in response to the change in the magnetic field and transmits the vibration through the vibration transmitting member to the vibration plate or to the housing of the acoustic device. When a user wears the acoustic device 100, the vibration plate or the housing of the acoustic device may come in contact with the skin of the user, and transmit the vibration to an auditory nerve by way of a bone-conducted sound wave through the skin, bones, or muscles of the user, so that the user may hear the sound. In some embodiments of the present disclosure, the shape of the housing of the acoustic device may be cylindrical, rounded, rectangular, or other three-dimensional structures. In some embodiments of the present disclosure, a material of the housing of the acoustic device may include plastic, resin, glass, metal, or the like. In some embodiments of the present disclosure, a contact region of the housing that is in contact with the skin of the user may be one sidewall of the housing. For example, if the housing of the acoustic device is a cylindrical structure, the contact region is a bottom wall of the housing of the acoustic device. In some embodiments of the present disclosure, the contact region may also be a localized region of the one sidewall of the housing of the acoustic device. For example, the one sidewall of the housing of the acoustic device has a projected region that protrudes with respect to a surface thereof, and the projected region is the contact region. In some embodiments of the present disclosure, the bone conduction vibrator 140 may include a vibration plate and a transducer. The transducer may be configured to generate a vibration, e.g., by converting the electrical signal corresponding to the first sound signal into a mechanical vibration. The transducer may drive the vibration plate to vibrate. Merely by way of example, the vibration plate may be mechanically connected to the transducer and vibrate with the transducer. In practical applications (e.g., when the user wears the acoustic device 100), the vibration plate may contact the skin of the user and transmit the vibration through tissues and bones of the user to the auditory nerve, thereby allowing the user to hear the sound.

In some embodiments of the present disclosure, the air conduction vibrator 150 may include a transducer device and a diaphragm. The transducer device and the diaphragm are disposed inside the housing of the acoustic device, and the transducer device may receive the second sound signal from the processing module 130 and drive the diaphragm to generate a vibration, thereby generating an air-conducted sound wave. In some embodiments of the present disclosure, the air conduction vibrator 150 may be an open structure that is disposed in a location near an ear of the user without blocking an ear canal of the ear. Accordingly, the housing of the acoustic device includes at least the contact region that contacts with the facial region of the user. In some embodiments of the present disclosure, the transducer device may include an electromagnetic type (e.g., a moving coil type, a moving iron type, etc.), a piezoelectric type, an inverse piezoelectric type, an electrostatic type, or the like. In some embodiments of the present disclosure, the housing of the acoustic device may include one or more sound guiding holes that facing towards an opening of the ear canal when the user is wearing the acoustic device 100. The one or more sound guiding holes may be configured to connect an accommodation cavity inside the housing with an external environment, and transmit the air-conducted sound wave inside the housing of the acoustic device to the external environment, thereby transmitting the sound to the user in an air-conducted manner.

In some embodiments of the present disclosure, the processing module 130 may perform high-pass filtering and low-pass filtering on the electrical signal containing the sound information to obtain the first sound signal and the second sound signal.

In some embodiments of the present disclosure, a cutoff frequency of a high-pass filter is the second frequency division point, and after the electrical signal containing the sound information is processed through the high-pass filtering, a portion that is lower than the cutoff frequency (i.e., the second frequency division point) is filtered out, so that a high-frequency component above the cutoff frequency is mainly retained. The processing module 130 divides the input electrical signal containing the sound information into the first sound signal based on the high-frequency component. In some embodiments, a cutoff frequency of a low-pass filter is the second frequency division point, and after the electrical signal containing the sound information is processed through the low-pass filtering, a portion that is higher than the cutoff frequency (i.e., the second frequency division point) is filtered out, so that a low-frequency component that is below the cutoff frequency is mainly retained. The processing module 130 divides the input electrical signal containing the sound information into the second sound signal based on the low-frequency component. In some embodiments, the cutoff frequency of the low-pass filter may be lower than the cutoff frequency of the high-pass filter. In some embodiments, the cutoff frequency of the low-pass filter may be higher than the cutoff frequency of the high-pass filter, and there is an overlapping frequency portion between the frequency components of the first sound signal and the second sound signal, and the overlapping frequency portion may simultaneously generate the bone-conducted sound and the air-conducted sound, thereby improving a listening effect for the user. In some embodiments of the present disclosure, a difference between the cutoff frequency of the high-pass filter and the cutoff frequency of the low-pass filter may be in a range of -200Hz to 200Hz, such that the low-frequency component and the high-frequency component of a speech signal synthesized by the processing module 130 have a high quality while circumventing an impact of the wind noise.

In some embodiments, the processing module 130 may process the electrical signal containing the sound information to obtain the first sound signal and the second sound signal through other processing methods. For example, the processing module 130 includes an audio power amplifier to amplify the input electrical signal containing the sound information to a suitable level to obtain the first sound signal and the second sound signal with sufficient levels.

In some embodiments, the electrical signal containing the sound information refers to an audio signal. The audio signal refers to an information carrier of frequency and amplitude changes of a regular sound wave with speech, music, and sound effects. In some embodiments, the audio signal may be stored in an internal storage of the acoustic device 100, or may be transmitted between devices connected by communications, or the like. For example, the audio signal stored in the internal storage of the acoustic device 100 may include a white noise signal, a pure tone signal, an impulse signal, a narrow-band noise, a narrow-band warble tone, a modulated tone and/or a swept-tone signal, or a music signals, or the like.

In some embodiments, the acoustic device 100 may output the bone-conducted sound through the bone conduction vibrator 140, and the vibration generated by the bone conduction vibrator 140 is received by the bone conduction microphone 110, causing the sound output by the acoustic device 100 to have an echo. In some embodiments, the second frequency division point is higher than the first frequency division point, which allows the bone conduction vibrator 140 to output a bone-conducted sound above the second frequency division point, avoiding the frequency range of the low-frequency component mainly picked up by the bone conduction microphone 110, thereby effectively preventing the bone conduction vibrator 140 from affecting the bone conduction microphone 110. At the same time, since the air-conducted sound wave has a minimal impact on the bone conduction microphone 110, the air conduction vibrator 150 can output an electrical signal containing sound information below the second frequency division point as the air-conducted sound, ensuring that the user can still hear sounds below the second frequency division point.

In some embodiments, the first frequency division point may be in a range of 500 Hz-1000 Hz, and the second frequency division point may be in a range above 1000 Hz.

In some embodiments, the second frequency division point may be not less than 1 time, 1.4 times, 1.5 times, 2 times, or more than 2 times of the first frequency division point. Preferably, the second frequency division point is in a range of 1000 Hz-3000 Hz. More preferably, the second frequency division point is in a range of 1300 Hz-2500 Hz. In some embodiments, by setting the second frequency division point to be not less than 1000 Hz, the impact of the bone-conducted sound output by the bone conduction vibrator 140 on the bone conduction microphone 110 can be effectively avoided, ensuring that the speech signal generated by the bone conduction microphone 110 has no echoes and improving the quality of the synthesized speech signal reflecting the speech content of the user.

It should be noted that due to the low-frequency component extracted from the first sound pickup signal may still contain a portion of the speech signal after the first frequency division point, to better avoid the impact of the bone conduction vibrator 140 on the bone conduction microphone 110, a difference between the first frequency division point and the second frequency division point may not be too small. At the same time, in a specific frequency range (e.g., 1000 Hz-2000 Hz), an effect of bone-conducted sound is better than an effect of the air-conducted sound. Therefore, although the second frequency division point is higher than the first frequency division point, the second frequency division point may not be excessively higher than the first frequency division point, thereby ensuring a better listening effect for the user.

In some embodiments, the difference between the second frequency division point and the first frequency division point may be in a range of 100 Hz-1700 Hz, 300 Hz-1700 Hz, or 500 Hz-1500 Hz. In some embodiments, a ratio of the first frequency division point to the second frequency division point may be in a range of 0.2-1, 0.3-0.8, or 0.3-0.9. Preferably, the ratio of the first frequency division point to the second frequency division point is in a range of 0.3-0.8.

In some embodiments of the present disclosure, by setting the second frequency division point to be not excessively higher than the first frequency division point, it is ensured that the acoustic device 100 utilizes the bone conduction vibrator 140 to output the speech signal in a specific frequency range as a bone-conducted sound with a relatively good effect. This configuration prevents the bone-conducted sound output by the bone conduction vibrator 140 from affecting the bone conduction microphone 110's ability to capture the voice of the user, thereby preventing the acoustic device 100 from generating echoes and improving the quality of the synthesized speech signal reflecting the speech content of the user.

In some embodiments, based on frequency response curves of the signals output by the bone conduction vibrator 140 and the air conduction vibrator 150 under white noise or sweep excitation, a frequency near an intersection point of the frequency response curves is determined as the second frequency division point of the acoustic device 100. In some embodiments, the second frequency division point is any point within ±300 Hz of the intersection point of the two frequency response curves. Specifically, in some implementations, the frequency response curve of the bone conduction vibrator 140 is measured as follows: an air conduction microphone is placed within 1 cm to 2 cm from the bone conduction vibrator 140; when the bone conduction vibrator 140 operates, it causes a vibration in the surrounding air, which is transmitted to the air conduction microphone via air conduction; and the air conduction microphone captures the vibration to obtain the frequency response curve of the bone conduction vibrator 140.

In some embodiments, the acoustic device 100 may include a housing, and the bone conduction microphone 110 is provided on the housing of the acoustic device 100. More descriptions of the housing may be found in the related descriptions above.

In some embodiments of the present disclosure, by setting the bone conduction microphone 110 on a side of the housing that is in contact with the facial skin of the user, a damping effect of the facial skin provides friction and cushioning for the bone conduction microphone 110, which prevents the bone conduction microphone 110 from being affected by a noise vibration signal due to the housing being excited by a high-speed wind, thereby reducing an impact of an airflow turbulence on the bone conduction microphone 110 and minimizing the wind noise. Additionally, placing the bone conduction microphone 110 on the side in contact with the facial skin facilitates the reception of the skin vibration when the user speaks, achieving better sound pickup performance.

It may be understood that, in some other embodiments of the present disclosure, the bone conduction microphone 110 may also be disposed in other locations of the housing, such as on a side adjacent to the side in contact with the skin of the user or on a surface opposite to the side in contact with the skin of the user. In some embodiments, the bone conduction microphone 110 may also be placed inside the housing. The bone conduction microphone may respond to an interior of the housing, which receives a vibration from the skin of the user when the user speaks. The bone conduction microphone 110 captures the vibration from the housing and converts the vibration into an electrical signal (the first sound pickup signal).

In some embodiments, to ensure that the bone conduction vibrator 140 has a high vibration transmission efficiency, a vibration direction of the bone conduction vibrator 140 is typically approximately perpendicular to the face-contacting side or the vibration plate of the housing of the acoustic device. "Approximately perpendicular" may be understood as being within a range of 70° to 120°. In some embodiments, an angle between a vibration direction (i.e., a sensitive direction) of the bone conduction microphone 110 and the vibration direction of the bone conduction vibrator 140 is not greater than 25°. In some embodiments of the present disclosure, based on the vibration direction of the bone conduction vibrator 140 being approximately perpendicular to the face-contacting side or the vibration plate of the housing of the acoustic device, by setting the angle between the vibration direction of the bone conduction microphone 110 and the vibration direction of the bone conduction vibrator 140 to be not greater than 25°, the vibration transmission efficiency of the bone conduction vibrator 140 through the face is effectively ensured. Additionally, the bone conduction microphone 110 also achieves a high vibration pickup efficiency at that angle.

In some embodiments, the angle between the vibration direction of the bone conduction microphone 110 and the vibration direction of the bone conduction vibrator 140 may be within a range of 0° to 15° or 5° to 25°. In some embodiments, when the vibration direction of the bone conduction microphone 110 is parallel to the vibration direction of the bone conduction vibrator 140 (i.e., the angle is 0°), and the vibration direction of the bone conduction microphone 110 and the vibration direction of the bone conduction vibrator 140 are essentially aligned, the bone conduction microphone 110 achieves a highest vibration pickup efficiency.

In some embodiments, the at least one air conduction microphone 120 may include a first air conduction microphone and a second air conduction microphone. When the user wears the acoustic device 100, a line connecting the first air conduction microphone and the second air conduction microphone points toward a mouth region of the user.

The line connecting the first air conduction microphone and the second air conduction microphone pointing to the mouth region of the user refers that a line connecting centers of sound inlets corresponding to the first air conduction microphone and the second air conduction microphone points toward the mouth region of the user.

In some embodiments, when the acoustic device 100 has two air conduction microphones 120, the first air conduction microphone is closer to the mouth region of the user, and the second air conduction microphone is relatively farther from the mouth region of the user compared to the first air conduction microphone, thereby ensuring the directionality of the aforementioned line. Furthermore, based on a time difference between a sound captured by the first air conduction microphone and a sound captured by the second air conduction microphone, a direction of a sound source may be determined. Signal processing techniques (e.g., differential processing, subtraction, beamforming, etc.) may then be applied to effectively reduce environmental noise interference with the speech signal, thereby obtaining a clearer speech signal.

In some embodiments of the present disclosure, by providing a first air conduction microphone 120-1 and a second air conduction microphone 120-2 such that the line connecting the two air conduction microphones (or their corresponding sound inlets) points toward the mouth region of the user, the first air conduction microphone 120-1 and the second air conduction microphone 120-2 can form a basic microphone array, which facilitates processing to reduce an environmental noise, thereby ensuring better sound pickup performance when the user wears the acoustic device. Moreover, this configuration maximizes voice capture effectiveness, further enhancing the sound pickup performance of the air conduction microphones when the user wears the acoustic device.

In the embodiment of the present disclosure, at least one of the first air conduction microphone 120-1 and the second air conduction microphone 120-2 may be placed in a low-flow velocity region. The low-flow velocity region refers to a region where the wind speed is relatively low compared to other positions when the user engages in activities such as cycling or running while wearing the acoustic device 100. For example, the low-flow velocity region may include a side of an ear hook of the acoustic device 100 facing the back of the head or a side of the housing of the acoustic device 100 facing the back of the head. When the user wears the acoustic device 100 during activities such as cycling or running, at least one of the first air conduction microphone 120-1 and the second air conduction microphone 120-2 is positioned in a region with relatively lower wind speed to minimize the impact of the wind noise, thereby ensuring that at least one air conduction microphone maintains good sound pickup performance, and guaranteeing effective call quality even during physical activities.

In some application scenarios, for example, when the user is using the acoustic device 100 for making a call or recording a sound, the processing module 130 may determine whether the user is in a wind noise state based on an external sound signal collected by the first air conduction microphone 120-1 and an external sound signal collected by the second air conduction microphone 120-2, respectively. If the user is in the wind noise state, the processing module 130 controls the one, disposed in the low-flow velocity region (e.g., the side of the ear hook facing the back of the head or the side of the housing of the acoustic device 100 facing the back of the head), of the first air conduction microphone 120-1 and the second air conduction microphone 120-2 to collect the speech signal of the user. In this case, the impact of the wind noise on the sound signals collected by the air conduction microphones can be reduced, thereby improving the sound pickup performance of the air conduction microphones in the acoustic device 100. If the user is not in the wind noise state, the processing module 130 controls one, closer to the mouth region of the user, of the first air conduction microphone 120-1 and the second air conduction microphone 120-2 to collect the sound signal when the user is speaking. In this case, the air conduction microphone closer to the mouth region of the user is nearer to the mouth region of the user and receives a relatively strong sound signal from the user.

In some embodiments of the present disclosure, to determine whether the user is in the wind noise state based on the external sound signal collected by the first air conduction microphone 120-1 and the external sound signal collected by the second air conduction microphone 120-2, the processing module 130 is further configured to determine whether a correlation between the external sound signal collected by the first air conduction microphone 120-1 and the external sound signal collected by the second air conduction microphone 120-2 is greater than a correlation threshold (e.g., 90%). If the correlation is greater than the correlation threshold, the processing module 130 determines that the user is not in the wind noise state; if the correlation is less than the correlation threshold, the processing module 130 determines that the user is in the wind noise state. Specifically, conventional noises in the external environment (e.g., speech sounds of other people around the user, external car sirens, music, etc.) may be transmitted to the first air conduction microphone 120-1 and the second air conduction microphone 120-2 at the same time. However, since the first air conduction microphone 120-1 and the second air conduction microphone 120-2 are disposed at different locations of the acoustic device, the wind noise typically propagates with a delay in a specific direction, causing a significant difference between the external sound signals collected by the first air conduction microphone 120-1 and the second air conduction microphone 120-2. Based on this principle, in different scenarios, operating states of different air conduction microphones in the acoustic device 100 may be adjusted to reduce the impact of the external wind noise on the collected sound signal when the user is speaking.

In some embodiments of the present disclosure, the acoustic device 100 may have only one air conduction microphone 120.

In some embodiments of the present disclosure, when the acoustic device 100 has only one air conduction microphone 120, the air conduction microphone 120 may be disposed in the low-flow velocity region of the acoustic device 100. For example, the low-flow velocity region may include the side of the ear hook of the acoustic device 100 facing the back of the head or the side of the housing of the acoustic device 100 facing the back of the head. If a distance between the first air conduction microphone and the second air conduction microphone is too small, differences between amplitudes and phases of the low-frequency sound signals received by the first air conduction microphone and the second air conduction microphone become too minor, thus increasing the difficulty of subsequent low-frequency signal processing. Therefore, the distance between the first air conduction microphone and the second air conduction microphone may not be too small. Thus, an appropriate distance is required between the first air conduction microphone and the second air conduction microphone to facilitate subsequent signal processing. In some embodiments, the distance between the first air conduction microphone and the second air conduction microphone is not less than 10 mm. To ensure portability of the earphone and comfort of the user when wearing the acoustic device, a size of the acoustic device may not be too large. Correspondingly, the distance between the first air conduction microphone and the second air conduction microphone is limited by the size of the acoustic device. In some embodiments, the distance between the first air conduction microphone and the second air conduction microphone is not greater than 50 mm. In some embodiments, considering the size limitation of the acoustic device and to ensure good sound pickup performance and ease of subsequent signal processing, the distance between the first air conduction microphone and the second air conduction microphone may be within a range of 10 mm to 50 mm.

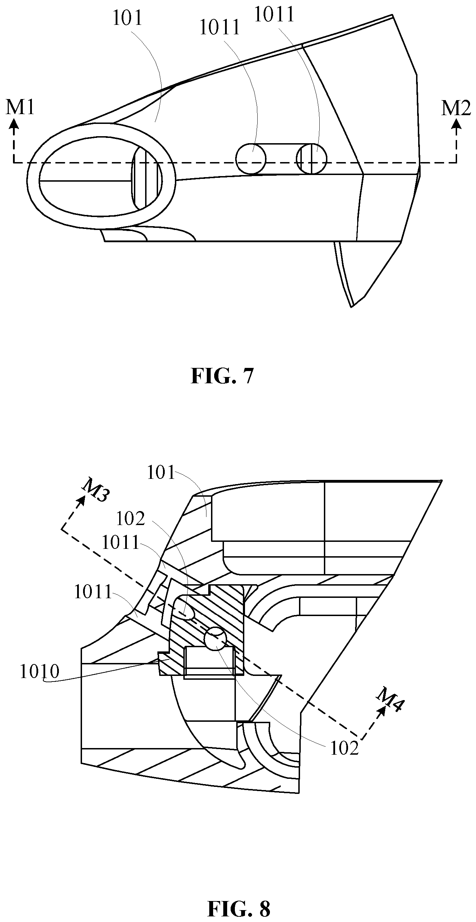

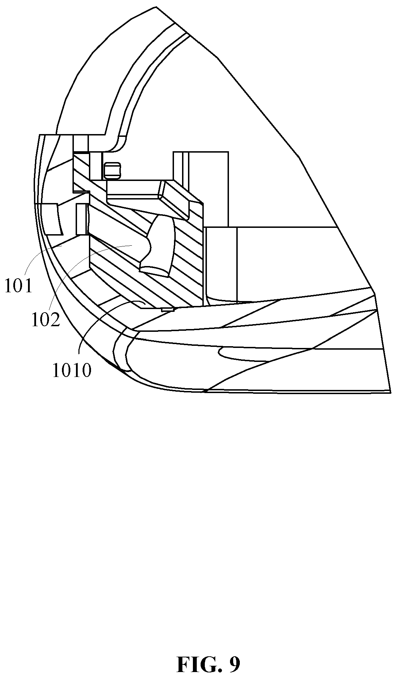

FIG. 7 is a schematic structural diagram of a sound inlet opened on a housing according to some embodiments of the present disclosure. FIG. 8 is a schematic cross-sectional view taken along a line M1-M2 of FIG. 7 according to some embodiments of the present disclosure. FIG. 9 is a schematic cross-sectional view taken along a line M3-M4 of FIG. 8 according to some embodiments of the present disclosure.

Referring to FIG. 7, FIG. 8, and FIG. 9, in some embodiments of the present disclosure, the air conduction microphone 120 is disposed inside a housing 101 of the acoustic device 100, and an air-conducted sound wave is collected through a sound inlet 1011 of the housing 101. In some embodiments, a sound guiding channel 102 is provided between the sound inlet 1011 and the air conduction microphone 120. In some embodiments, a length of the sound guiding channel 102 may be configured to be in a range of 3mm to 20mm.

Optionally, the housing 101 is provided with at least two sound inlets 1011. The air conduction microphone 120 may be configured to collect an external sound entering through the at least two sound inlets 1011. In some embodiments, one air conduction microphone 120 may collect the external sound entering through two sound inlets 1011. Sound inlet ends of the two sound inlets 1011 may be spaced apart from each other, while sound outlet ends of the two sound inlets 1011 may be interconnected. The sound inlet end of the sound inlet 1011 refers to an end where the external sound enters the sound inlet 1011. The sound outlet end of the sound inlet 1011 refers to an end where the external sound exits after passing through the sound inlet 1011. By interconnecting the sound outlet ends of the two sound inlets 1011, pressure balance within the entire sound guiding channel 102 can be achieved, thereby preventing airflow stagnation and avoiding direct transmission of external pressure changes to the air conduction microphone 120.

In this embodiment, a ratio of a distance between the sound inlet ends of the two sound inlets 1011 to a diameter of each of the two sound inlets 1011 is between 0.5 and 3.

Optionally, the sound inlet end of each of the two sound inlets 1011 is located on a side of the housing 101 facing the top of the head of the user along a vertical axis of the user and is shielded by the housing 101 or a wearing component along a sagittal axis of the user. That is to say, the sound inlet end may be located on a rear upper side of the housing 101. In this configuration, the sound inlet end of the sound inlet 1011 can be positioned in a relatively concealed region of the housing 101, shielded by the housing 101 or the wearing component (e.g., an ear hook), thereby increasing the difficulty for external airflow to enter the sound inlet 1011 and reducing the wind noise.

It should be noted that in the fields of medicine, anatomy, or the like, three basic sections including a sagittal plane, a coronal plane, and a horizontal plane of the human body may be defined, respectively, and three basic axes including a sagittal axis, a coronal axis, and a vertical axis may also be defined. As used herein, the sagittal plane refers to a section perpendicular to the ground along a front and rear direction of the body, which divides the human body into left and right parts. The coronal plane refers to a section perpendicular to the ground along a left and right direction of the body, which divides the human body into front and rear parts. The horizontal plane refers to a section parallel to the ground along an up-and-down direction of the body, which divides the human body into upper and lower parts. Correspondingly, the sagittal axis refers to an axis along the front- and-rear direction of the body and perpendicular to the coronal plane. The coronal axis refers to an axis along the left-and-right direction of the body and perpendicular to the sagittal plane. The vertical axis refers to an axis along the up-and-down direction of the body and perpendicular to the horizontal plane.

Specifically, for the user, in most scenarios, the user moves forward. That is to say, when the user wears the earphone, the airflow primarily comes from the front of the user (or the earphone). Therefore, by setting the sound inlet end at the rear side of the housing 101, most of the airflow from the front of the user can be blocked by the housing 101, and it is not easy to enter the sound inlet 1011. In addition, the auricle of the ear may have a sound gathering effect, which reduces the quality of the sound collected by the air conduction microphone 120. Therefore, setting the sound inlet end on an upper side of the housing 101 can reduce the impact of the sound gathering effect of the auricle.

Optionally, the housing 101 is provided with a first matching portion, and a wearing component (e.g., the ear hook) is provided with a second matching portion. The first matching portion and the second matching portion are not shown in the drawings. The first matching portion and the second matching portion are connected through matching (e.g., plugging, snapping, etc.) to achieve a connection between the wearing component and the housing 101. The sound inlet 1011 is set on the housing 101. A height of the first matching portion and/or a height of the second matching portion along the vertical axis is higher than the sound inlet end of the sound inlet 1011. The sound inlet end of the sound inlet 1011 is located on a side of the first matching portion and/or the second matching portion facing the back of the head of the user along the sagittal axis. In this case, when the user wears the earphone, the first matching portion and/or the second matching portion of the housing 101 can block airflow from the front of the user from entering the sound inlet 1011. In some embodiments, the first matching portion is a protruding structure extending from a side wall of the housing 101, and an end of the protruding structure away from the housing 101 is provided with a socket. Correspondingly, the second matching portion is an end of the wearing component (e.g., the ear hook), which may be plugged into the socket of the first matching portion to achieve the connection between the wearing component and the housing 101.

Optionally, a distance between the sound inlet end of the sound inlet 1011 and the first matching portion and/or the second matching portion along the sagittal axis is less than or equal to half of a maximum dimension of the housing 101 along the sagittal axis.

Optionally, the distance between the sound inlet end of the sound inlet 1011 and the first matching portion 1012 and/or the second matching portion along the sagittal axis is less than or equal to 5 mm. This arrangement positions the sound inlet end of the sound inlet 1011 closer to the first matching portion and/or the second matching portion. When the user wears the acoustic device, the sound inlet end of the sound inlet 1011 is located on the side of the first matching portion and/or the second matching portion facing the back of the head of the user along the sagittal axis, allowing the first matching portion and/or the second matching portion to better block airflow from the front of the user from entering the sound inlet 1011.

In some embodiments, the sound guiding channel 102 may also be provided between the sound inlet 1011 and the air conduction microphone 120. Considering the side wall of the housing 101 is relatively thin and may not form an effective sound guiding channel 102, thickening the housing 101 to directly create the sound guiding channel 102 may significantly increase the manufacturing difficulty of the housing 101. In some embodiments, the acoustic device may include a support base 1010, which is a three-dimensional structure. At least one side of the support base 1010 is connected to the side of the housing 101, and the sound guiding channel 102 is formed inside the support base 1010. Further, the sound inlet 1011 is formed on the side wall of the housing 101 and is acoustically connected to the sound guiding channel 102 of the support base 1010. In some embodiments, the sound guiding channel 102 may be arranged in a bent shape. For example, the sound guiding channel 102 may include a plurality of sequentially connected curved structures. This arrangement ensures that a volume of the support base 1010 may be relatively small, increases a length of the sound guiding channel 102, and slows down a speed of the airflow, thereby reducing the impact of the wind noise. If the length of the sound guiding channel 102 is too short, the effect of slowing down the speed of the airflow is not significant. If the length of the sound guiding channel 102 is too long, the volume of the support base 1010 may become too large, resulting in an oversized acoustic device and affecting the user's wearing experience. Therefore, in some embodiments, the length of the sound guiding channel 102 may be set within a range of 3 mm to 20 mm. The length of the sound guiding channel 102 refers to a length along an extending direction of the sound guiding channel 102. By setting the length of the sound guiding channel 102 to be in an appropriate range, the speed of the airflow can be slowed down, and the volume of the support base 1010 can be reasonably controlled.

In some embodiments of the present disclosure, by providing the sound guiding channel 102 between the sound inlet 1011 and the air conduction microphone 120, and setting the sound guiding channel in a bent shape to increase the length of the sound guiding channel, the speed of the airflow in the housing 10 can be effectively slowed down, thereby reducing the wind noise and improving the sound output performance of the acoustic device 100 (e.g., the earphone).

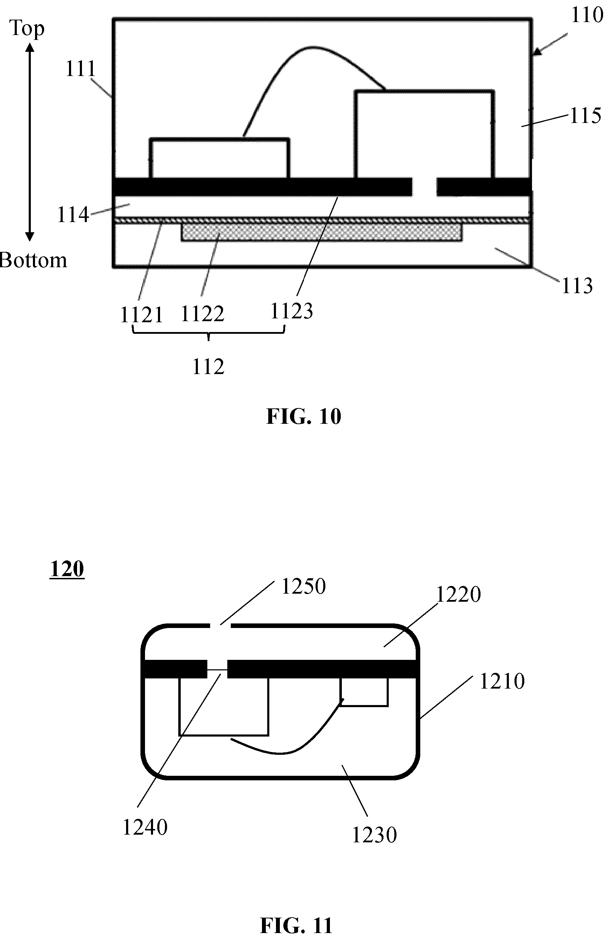

FIG. 10 is a schematic structural diagram of a bone conduction microphone according to some embodiments of the present disclosure.

Referring to FIG. 10, in some embodiments, the bone conduction microphone 110 may include a first supporting structure 111 and a vibration pickup unit 112. The vibration pickup unit 112 is located in a cavity inside the first supporting structure 111. The vibration pickup unit 112 of the bone conduction microphone 110 may include an elastic element 1121, a mass block 1122, and a transducer unit 1123. The mass block 1122 is located on the elastic element 1121, and the transducer unit 1123 includes a PCB board and a diaphragm. The PCB board is connected to an inner wall of the first supporting structure 111 through a peripheral side of the PCB board. The first supporting structure 111 vibrates in response to the vibration of the housing or the skin of the user, the elastic element 1121 and the mass block 1122 of the vibration pickup unit 112 receive the vibration of the first supporting structure 111, and the transducer unit 1123 converts the vibration into an electrical signal.

In some embodiments, the elastic element 1121 and the PCB board divide the cavity inside the first supporting structure 111 into a first cavity 113, a second cavity 114, and a third cavity 115. The first supporting structure 111 vibrates in response to the vibration of the housing or the skin of the user (e.g., moving along the vertical direction shown in FIG. 10). At this time, the elastic element 1121 and the mass block 1122 in the first cavity 113 move relative to the first supporting structure 111, causing a change in an internal pressure of the second cavity 114. The pressure change acts on a diaphragm of the transducer unit 1123, causing the diaphragm to vibrate, and the transducer unit 1123 converts the vibration of the diaphragm into an electrical signal.

In some embodiments, the first supporting structure 111 may be a closed structure, i.e., there are no openings connecting the cavity inside the first supporting structure 111 to an external environment. By designing the first supporting structure as the closed structure, external airflow turbulence cannot enter an interior of the first supporting structure 111, thereby significantly reducing the impact of air-conducted sound and wind noise on the bone conduction microphone 110, especially on the vibration pickup unit 112.

It should be noted that the bone conduction microphone 110 may also be the bone conduction microphones 110A, 110B, and 110C shown in FIG. 3 through FIG. 5, and the stacked structure described above may replace the vibration pickup unit 112 in FIG. 10. Furthermore, in some embodiments, the first supporting structure 111 may be a housing structure that is independent with respect to the housing of the acoustic device, i.e., the first supporting structure 111 may be provided on the housing of the acoustic device. In other embodiments of the present disclosure, the first supporting structure 111 may also be omitted, and the vibration pickup unit or the stacked structure may be disposed directly inside the housing of the acoustic device.

FIG. 11 is a schematic structural diagram of an air conduction microphone according to some embodiments of the present disclosure. As shown in FIG. 11, in some embodiments, the air conduction microphone 120 may include a second supporting structure 1210 and a diaphragm 1240. The diaphragm 1240 is located in a cavity of the second supporting structure 1210 and divides the cavity into a front chamber 1220 and a rear chamber 1230. The second supporting structure 1210 is provided with an opening 1250 to connect the front chamber 1220 to the external environment. An external sound may enter the interior of the second supporting structure 1210 through the opening 1250, causing a pressure change inside the front chamber 1220. The diaphragm 1240 vibrates in response to the pressure change, and a transducer unit inside the air conduction microphone 120 converts the vibration of the diaphragm into an electrical signal. It should be noted that the air conduction microphone 120 may be installed together with a bone conduction vibrator and an air conduction vibrator in a same carrier structure, such as a housing of an acoustic device. In this case, the second supporting structure is the housing of the acoustic device. In some embodiments, the second supporting structure may be a structure independent of the housing of the acoustic device, and the second supporting structure may be located outside or inside the housing.

Compared to the bone conduction microphone 110, the air conduction microphone 120 typically has only one cavity with an opening connected to the external environment to ensure a sound pressure difference between the front chamber 1220 and the rear chamber 1230, thereby improving sensitivity to the air-conducted sound. The above content distinguishes the bone conduction microphone 110 and the air conduction microphone 120 in terms of structures. In some embodiments, the bone conduction microphone and the air conduction microphone may also be distinguished by their effective operating frequencies. For example, an effective operating frequency of a conventional bone conduction microphone is generally within 10 kHz, and more specifically, the effective operating frequency of the conventional microphone is generally within a range of 35 Hz to 5 kHz. Correspondingly, an effective operating frequency of the air conduction microphone is broader than the effective operating frequency of the bone conduction microphone. For example, generally, the effective operating frequency of the air conduction microphone may reach up to 20 kHz.

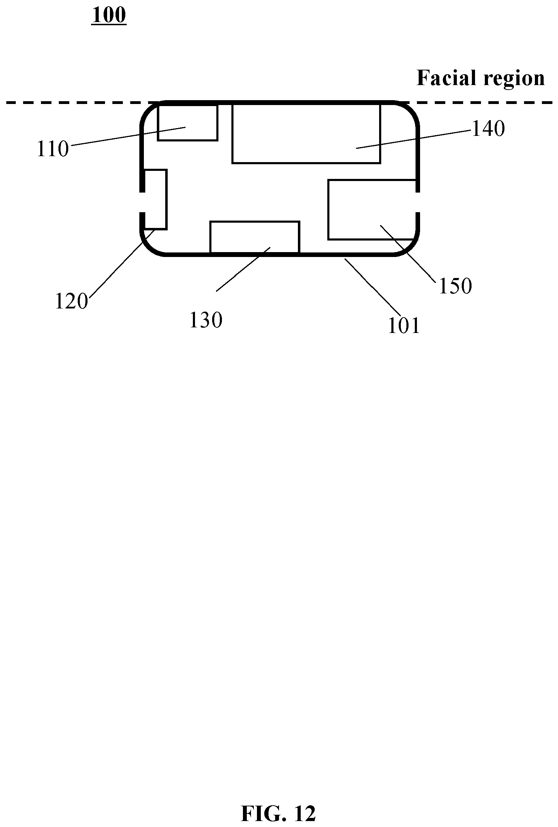

FIG. 12 is a structural diagram of an acoustic device according to some embodiments of the present disclosure. As shown in FIG. 12, the acoustic device 100 may include a housing 101, a bone conduction microphone 110, at least one air conduction microphone 120, a processing module 130, a bone conduction vibrator 140, and an air conduction vibrator 150. The bone conduction microphone 110, the at least one air conduction microphone 120, the processing module 130, the bone conduction vibrator 140, and the air conduction vibrator 150 are integrated with an internal cavity of the housing 101. When a user wears the acoustic device 100, a side of the housing 101 is configured to contact a facial region of the user. The bone conduction microphone 110 may be disposed on an exterior of a face-contacting side of the housing 101 to ensure a full contact between the bone conduction microphone 110 and the facial region of the user, thereby better collecting the first sound pickup signal generated when the user speaks. In other alternative embodiments, the bone conduction microphone 110 may be disposed on an interior of the face-contacting side of the housing 101, and the face-contacting side of the housing 101 may transmit the vibration to the bone conduction microphone 110. At the same time, the air conduction microphone 120 collects the second sound pickup signal transmitted via air conduction through the sound inlet on the housing. By using the bone conduction microphone 110 and the air conduction microphone 120 to separately collect the sound generated when the user is speaking, and processing the first sound pickup signal and the second sound pickup signal through the processing module 130, a low-frequency component of the first sound pickup signal and a high-frequency component of the second sound pickup signal are extracted and combined to synthesize a speech signal of the user. This approach reduces the impact of the wind noise while improving the quality of sound signals collected by the acoustic device 100 across different frequency ranges.

In some embodiments, a mechanical vibration generated by the bone conduction vibrator 140 driven by the first sound signal may be transmitted through the face-contacting side of the housing 101 to the facial region of the user, and then transmitted to an auditory nerve of the user via bone conduction through muscles, the blood, bones, etc., of the user. The air conduction vibrator 150, driven by the second sound signal, generates an air-conducted sound, which is transmitted through a sound outlet on the housing 101 to an eardrum of an ear of the user via air conduction. The acoustic device 100 may output a bone-conducted sound through the bone conduction vibrator 140. However, the vibration generated by the bone conduction vibrator 140 is inevitably received by the bone conduction microphone 110, causing the sound output by the acoustic device 100 to have an echo. In some embodiments, by setting the second frequency division point higher than the first frequency division point, the bone conduction vibrator 140 can output a bone-conducted sound above the second frequency division point, avoiding a frequency range primarily collected by the bone conduction microphone 110 for the low-frequency component, thereby effectively preventing the bone conduction vibrator 140 from affecting the bone conduction microphone 110. At the same time, since an air-conducted sound wave has a minimal impact on the bone conduction microphone 110, the air conduction vibrator 150 may output an electrical signal containing sound information below the second frequency division point as the air-conducted sound, ensuring that the user can still hear sounds below the second frequency division point.

It may be understood that in some other embodiments of the present disclosure, an operating state of the acoustic device may also be optimized through the acoustic device of the present disclosure. For example, the bone conduction vibrator 140 may vibrate in response to an audio signal, and the vibration may be transmitted to the user wearing the acoustic device via bone conduction. Since skin loads at different positions on the human body are different, the vibration of the bone conduction vibrator 140 is related to an actual wearing position of the user. A vibration signal of the housing of the acoustic device in contact with the skin of the user may be collected by the at least one bone conduction microphone. Furthermore, based on the audio signal and the vibration signal, a vibration response characteristic (e.g., one or more of a resonant frequency, a peak corresponding to a specific frequency, a quality factor, an input voltage, etc.) of the acoustic device may be determined. Based on the vibration response characteristic of the housing of the acoustic device, feedback on the operating state of the acoustic device may be provided to optimize its performance. In some embodiments, to provide the feedback on the operating state of the acoustic device, the processing module may be configured to: when the user is not wearing the acoustic device, generate a command to pause playback or adaptively adjust a power consumption of the acoustic device to reduce an energy consumption of the acoustic device. In some embodiments, to provide feedback on the operating state of the acoustic device, the processing module may be configured to: when the acoustic device is not worn properly, generate a prompt to remind the user to re-wear the acoustic device, thereby ensuring better sound quality and an improved auditory experience. In some embodiments, to provide the feedback on the operating state of the acoustic device, the processing module may be configured to: when the input voltage to the acoustic device is too low or too high, adaptively adjust an amplitude of the audio signal input to the acoustic device to ensure the user hears sound at an appropriate volume. In some embodiments, to provide feedback on the operating state of the acoustic device, the processing module may be configured to: when a clamping force of the acoustic device on the user is too low or too high, adaptively adjust the clamping force to ensure both efficient bone conduction transmission and user comfort. In some embodiments, to provide the feedback on the operating state of the acoustic device, the processing module may be configured to: when different users wear the acoustic device or a same user wears the acoustic device repeatedly, perform EQ compensation on the audio signal input to the acoustic device to ensure consistent sound effects for different users or different wearing manners. In some embodiments, providing the feedback on the operating state of the acoustic device can also enable monitoring of a physiological state of the user, allowing for supervision and feedback on a health condition of the user.

The basic concepts have been described above. It is evident that, for those skilled in the art, the descriptions provided herein are merely illustrative and do not constitute a limitation on the present disclosure. Although not explicitly stated here, those skilled in the art may make various modifications, improvements, and amendments to the present disclosure. Such modifications, improvements, and amendments are suggested within the present disclosure, and therefore, they still fall within the spirit and scope of the exemplary embodiments of the present disclosure.

## Claims

1. An acoustic device, comprising:
a bone conduction microphone configured to pick up a vibration generated when a user speaks to generate a first sound pickup signal;
at least one air conduction microphone configured to pick up an air-conducted sound generated when the user speaks to generate a second sound pickup signal; and
a processing module configured to synthesize a speech signal reflecting a speech content of the user based on a low-frequency component in the first sound pickup signal and a high-frequency component in the second sound pickup signal,
wherein the low-frequency component corresponds to frequencies below a first frequency division point, the high-frequency component corresponds to frequencies higher than the first frequency division point, and a resonant frequency of the bone conduction microphone is higher than the first frequency division point.

2. The acoustic device of claim 1, wherein the first frequency division point is within a range of 500 Hz to 1000 Hz.

3. The acoustic device of claim 2, wherein a difference between the resonant frequency of the bone conduction microphone and the first frequency division point is not less than 500 Hz.

4. The acoustic device of claim 1, further comprising:
a bone conduction vibrator configured to output a bone-conducted sound driven by a first sound signal; and
an air conduction vibrator configured to output an air-conducted sound driven by a second sound signal,
wherein the first sound signal includes a component higher than a second frequency division point, the second sound signal includes a component lower than the second frequency division point, and the first frequency division point is lower than the second frequency division point.

5. The acoustic device of claim 4, wherein the second frequency division point is not less than 1000 Hz.

6. The acoustic device of claim 5, wherein the second frequency division point is within a range of 1000 Hz to 2500 Hz.

7. The acoustic device of claim 4, wherein a difference between the second frequency division point and the first frequency division point is within a range of 100 Hz to 2000 Hz.

8. The acoustic device of claim 4, wherein a ratio of the first frequency division point to the second frequency division point is within a range of 0.2 to 1.

9. The acoustic device of claim 4, further comprising:
a housing, wherein the bone conduction microphone is disposed on a side of the housing, and the side of the housing is configured to contact the skin of the user.

10. The acoustic device of claim 4, wherein an angle between a vibration direction of the bone conduction microphone and a vibration direction of the bone conduction vibrator is not greater than 25°.

11. The acoustic device of claim 1, wherein the at least one air conduction microphone includes a first air conduction microphone and a second air conduction microphone, and when the user wears the acoustic device, a connecting line between the first air conduction microphone and the second air conduction microphone points toward a mouth region of the user.

12. The acoustic device of claim 11, wherein a distance between the first air conduction microphone and the second air conduction microphone is within a range of 10 mm to 50 mm.

13. The acoustic device of claim 11, wherein, in a wearing state, one of the first air conduction microphone and the second air conduction microphone is disposed in a low-flow velocity region on a side of the acoustic device facing back of the head of the user.

14. The acoustic device of claim 13, wherein the processing module is further configured to:
determine whether the user is in a wind noise state based on an external sound signal collected by the first air conduction microphone and an external sound signal collected by the second air conduction microphone;
if the user is in the wind noise state, control the one, disposed in the low-flow velocity region, of the first air conduction microphone and the second air conduction microphone to collect a sound signal when the user is speaking; and
if the user is not in the wind noise state, control one, closer to the mouth region of the user, of the first air conduction microphone and the second air conduction microphone to collect the sound signal when the user is speaking.

15. The acoustic device of claim 14, wherein to determine whether the user is in the wind noise state based on the external sound signal collected by the first air conduction microphone and the external sound signal collected by the second air conduction microphone, the processing module is further configured to:
determine whether a correlation between the external sound signal collected by the first air conduction microphone and the external sound signal collected by the second air conduction microphone is greater than a correlation threshold;
if the correlation is greater than the correlation threshold, determine that the user is not in the wind noise state; and
if the correlation is less than the correlation threshold, determine that the user is in the wind noise state.

16. The acoustic device of claim 1, wherein the bone conduction microphone includes a first supporting structure and a vibration pickup unit,
the vibration pickup unit is located in a cavity inside the first supporting structure, and includes an elastic element and a mass block, the mass block being located on the elastic element,
the first supporting structure vibrates in response to a vibration of a housing of the acoustic device or the user's skin, and the vibration pickup unit receives the vibration of the first supporting structure and converts the vibration into an electrical signal.

17. The acoustic device of claim 1, wherein the bone conduction microphone includes a first supporting structure and a vibration pickup unit, the vibration pickup unit is located in a cavity inside the first supporting structure, and the first supporting structure is a closed structure.

18. The acoustic device of claim 1, wherein the air conduction microphone includes a second supporting structure and a diaphragm,
the diaphragm is located in a cavity of the second supporting structure and divides the cavity into a front chamber and a rear chamber, and
the second supporting structure is provided with an opening for connecting the front chamber to an external environment.

19. The acoustic device of any one of claims 1 to 18, wherein the processing module is further configured to:
obtain a vibration signal through the bone conduction microphone, the vibration signal being at least partially derived from a vibration of a housing of the acoustic device in response to an audio signal, the vibration of the housing being configured to be transmitted to the user wearing the acoustic device in a bone conduction manner;
determine a vibration response characteristic of the housing based on the vibration signal and the audio signal; and
provide feedback on an operating state of the acoustic device based on the vibration response characteristic of the housing.
